# EUROPÄISCHE PATENTSCHRIFT

(11) **EP 1 788 625 B1**
(45) Veröffentlichungstag und Bekanntmachung des Hinweises auf die Patenterteilung: **02.06.2010**
(21) Anmeldenummer: 06023026.5
(22) Anmeldetag: 06.11.2006
(51) Int. Cl.: H01L 23/48, H02M 7/00

(54) **Modul mit elektrisch druckkontaktierten Kondensatoren**
Module with electrical pressure contacted capacitors
Module avec condensateurs à contact électrique par pression

(30) Priorität: 22.11.2005 DE 102005055608
(43) Veröffentlichungstag der Anmeldung: 23.05.2007
(73) Patentinhaber: Semikron Elektronik GmbH & Co. KG Patentabteilung, 90431 Nürnberg (DE)
(72) Erfinder: Beckedahl, Peter, 90522 Oberasbach (DE); Hager, Ludwig, 90491 Nürnberg (DE)

(56) Entgegenhaltungen:
- EP-A2- 0 994 557
- EP-A2- 1 450 404
- US-A1- 2004 179 341

## Beschreibung

Die Erfindung betrifft ein Leistungshalbleitermodul mit zueinander parallel geschalteten Kondensatoren, deren erste Anschlusselemente mit einer ersten Stromschiene und deren zweite Anschlusselemente mit einer zweiten Stromschiene kontaktiert sind, wobei zwischen den beiden Stromschienen ein Isolierelement vorgesehen ist, und das eine Druckeinrichtung aufweist.

Derartige Leistungshalbleitermodul sind beispielsweise bei Umrichtersystemen bekannt, bei welchen die Kondensatoren mit den beiden Stromschienen durch Löt-, Schweiß- oder Schraubkontakte elektrisch verbunden sind. Derartige Löt-, Schweiß- oder Schraubkontakte lassen bezüglich ihrer Zuverlässigkeit noch Wünsche offen.

Bei hochzuverlässigen Leistungshalbleitermodulen sind bei der Chip- und DCB-Kontaktierung Druckkontakte bevorzugt. Bei den Anschlusselementen der Kondensatoren wurde eine solche Druckkontaktierung bislang jedoch nicht realisiert, weil die Anschlusselemente der Kondensatoren sich in einer anderen Ebene oder in einer anderen Richtung als die DCB-Kontakte orientiert sind und folglich ein zusätzliches Drucksystem erforderlich wäre.

Die US 2004/0179341 A1 offenbart ein Leistungshalbleitermodul mit einem Kondensatorglättungsmodul, welches aus einer Mehrzahl einzelner Kondensatoren besteht und welches Hauptanschlusselemente zur direkten Kontaktierung mit den Anschlusselementen des Leistungshalbleitermoduls aufweist. Das Glättungskondensatormodul weist ein eigenes Gehäuse mit einer Halteplatte an dessen Oberseite und einem Kühlkörper an dessen Unterseite auf, wobei die Halteplatte dazu dient, die einzelnen Kondensatoren durch Druckbeaufschlagung in ihrer Position zu fixieren.

In Kenntnis dieser Gegebenheiten liegt der Ereindung die Aufgabe zugrunde, ein Leistungshalbleitermodul der eingangs genannten Art mit einer zuverlässigen Kontaktierung der Anschlusselemente der Kondensatoren zu schaffen, und das kostengünstig herstellbar ist.

Diese Aufgabe wird erfindungsgemäß durch die Merkmale des Anspruches 1, d.h. dadurch gelöst, dass die Druckeinrichtung mindestens einen Druckkörper und einen zugeordneten Gegendruckkörper aufweist, wobei die ersten und zweiten Anschlusselemente der Kondensatoren mit den zugeordneten Stromschienen durch die Druckeinrichtung mit Druck beaufschlagt und elektrisch kontaktiert werden.

Bei den Kondensatoren des erfindungsgemäßen Leistungshalbleitermodul sind die Anschlusselemente bspw. als Lötkondensator-Beinchen ausgebildet. Derartige Kondensatoren werden bislang durch Lötverbindungen mit den Stromschienen kontaktiert. Anstelle solcher Lötverbindungen wird erfindungsgemäß eine Druckkontaktierung vorgeschlagen, wie sie bei hochzuverlässigen Systemen von Umrichtersystemen oder dergleichen nur bei der Chip- und DCB-Kontaktierung realisiert sind.

Als zweckmäßig hat es sich bei dem erfindungsgemäßen Leistungshalbleitermodul erwiesen, wenn der mindestens eine Druckkörper zur Druckbeaufschlagung der ersten Anschlusselemente elastisch ausgebildete erste Arme aufweist und der zugeordnete Gegendruckkörper starr ausgebildet ist, und wer der mindestens eine Druckkörper zur Druckbeaufschlagung der zweiten Anschlusselemente starr ausgebildete zweite Arme und der zugeordnete Gegendruckkörper elastisch ausgebildete Abschnitte aufweist. Die elastisch ausgebildeten Abschnitte des Gegendruckkörpers können als freigestellte Stege ausgebildet sein.

Als vorteilhaft hat es sich erwiesen, wenn bei dem erfindungsgemäßen Leistungshalbleitermodul die ersten und zweiten Arme des mindestens einen Druckkörpers eng benachbart vorgesehen sind und vom Druckkörper parallel wegragen. Außerdem ist es zweckmäßig, wenn die ersten und zweiten Arme vom Druckkörper gleich weit wegragen.

Eine zuverlässige Druckkontaktierung der Anschlusselemente der Kondensatoren ergibt sich, wenn die elastisch ausgebildeten Abschnitte des Gegendruckkörpers mit den zweiten Armen des mindestens einen Druckkörpers deckungsgleich vorgesehen sind.

Als zweckmäßig hat es sich erwiesen, wenn die Kondensatoren zwischen dem Druck- und dem Gegendruckkörper der Druckeinrichtung gesichert festgelegt sind, um die jeweiligen Anforderungen bezüglich Rüttel- und Stoßfestigkeit des Leistungshalbleitermoduls zu erfüllen. Zu diesem Zwecke kann vom Druckkörper ein zur ersten und zweiten Stromschiene parallel orientiertes, längliches Halteorgan wegragen, das ein Polsterelement aufweist, und kann der Gegendruckkörper mit Positionierelementen für die Kondensatoren ausgebildet sein. Bei dem Polsterelement kann es sich um einen Streifen aus einem Kunststoff-Schaummaterial handeln, der an der dem Gegendruckkörper zugewandten Seite des Halteorgans festgelegt ist. Die Positionierelemente des Gegendruckkörpers können von Rinnen und/oder von konturierten Stegen gebildet sein, die mit den Gegendruckkörper materialeinstückig ausgebildet sind.

Bei dem erfindungsgemäßen Leistungshalbleitermodul sind die Kondensatoren zueinander parallel nebeneinander in einer Reihe neben der ersten und zweiten Stromschiene vorgesehen und liegen mindestens annähernd in der Ebene der ersten und zweiten Stromschiene.

Weitere Einzelheiten, Merkmale und Vorteile ergeben sich aus der nachfolgenden Beschreibung eines in der Zeichnung abschnittweise dargestellten Ausführungsbeispieles des erfindungsgemäßen Leistungshalbleitermoduls.

Es zeigen:
- Figur 1: eine perspektivische Ansicht einer Ausbildung des Leistungshalbleitermoduls,
- Figur 2: eine perspektivische Teilansicht des Leistungshalbleitermoduls, zur Verdeutlichung der Druckkontaktierung der beiden Kondensator-Anschlusselemente mit den zugehörigen Stromschienen, und
- Figur 3: eine andere perspektivische Teilansicht des Leistungshalbleitermoduls, insbesondere zur Verdeutlichung der Positionierelemente für die Kondensatoren sowie eines elastischen Elementes für ein zweites Anschlusselement eines Kondensators.

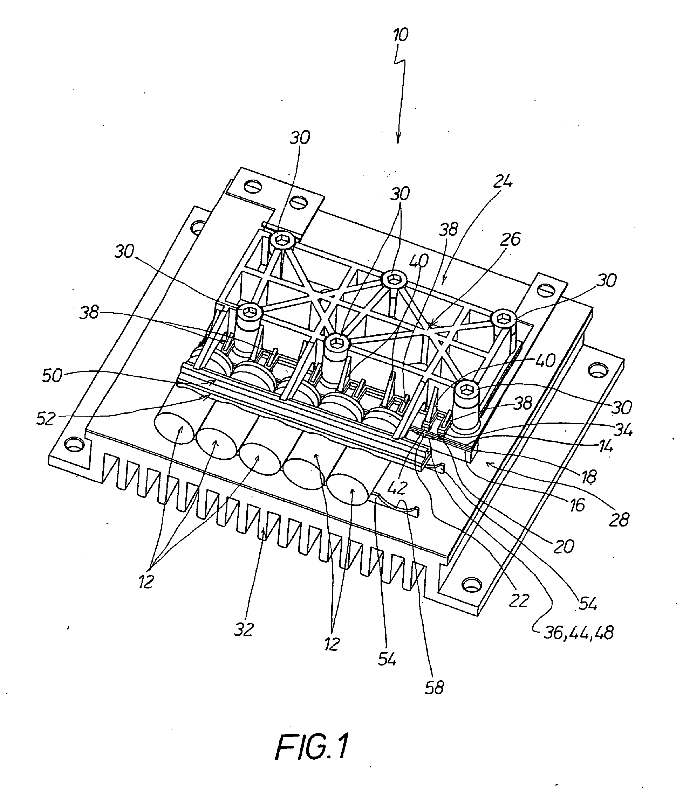

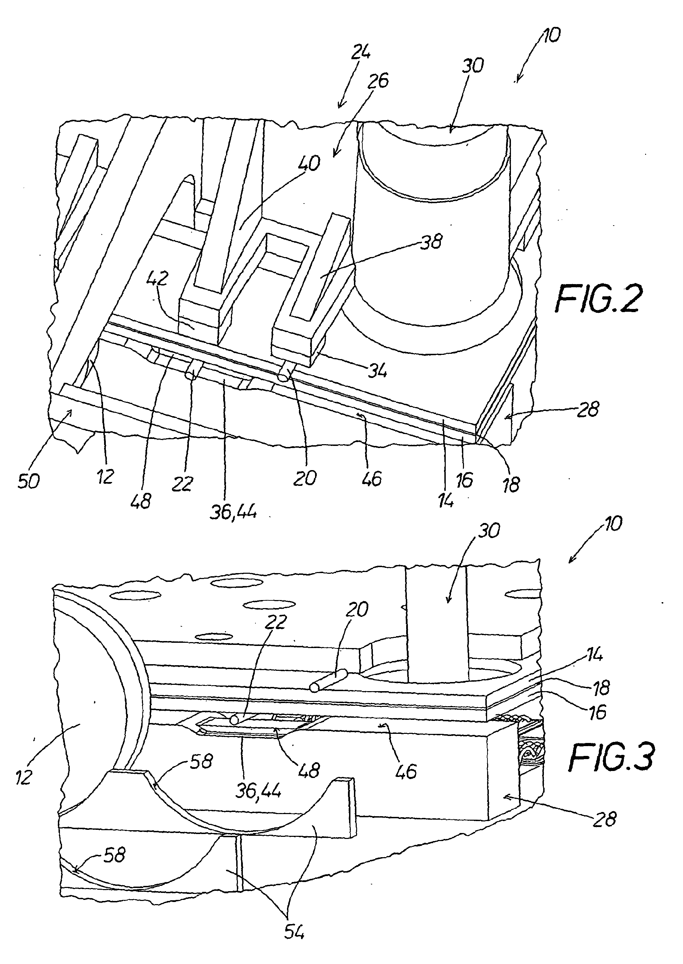

Figur 1 zeigt eine Ansicht des Leistungshalbleitermoduls 10 mit Kondensatoren 12, die in einer Reihe eng nebeneinander angeordnet und die zueinander parallel geschaltet sind. Diese Parallelschaltung erfolgt durch eine erste Stromschiene 14 und eine zweite Stromschiene 16, zwischen welchen ein Isolierelement 18 angeordnet ist. Die erste Stromschiene 14 ist mit ersten Anschlusselementen 20 der Kondensatoren 12 und die zweite Stromschiene 16 ist mit zweiten Anschlusselementen 22 (siehe auch Figur 2) der Kondensatoren 12 kontaktiert. Diese Kontaktierung der Anschlusselemente 20 und 22 mit den Stromschienen 14 und 16 wird mit einer Druckeinrichtung 24 des Leistungshalbleitermoduls 10 bewirkt, die einen Druckkörper 26 und einen Gegendruckkörper 28 aufweist. Die Druckeinrichtung 24 dient gleichzeitig zur Druckkontaktierung beispielsweise von Halbleiter-Chips mit einer nicht dargestellten Schaltungsplatine, eines Schaltungssubstrates oder dergleichen.

Der Druckkörper 26 ist mit dem Gegendruckkörper 28 mittels Schraubelementen 30 verspannt. Eine andere Möglichkeit besteht beispielsweise darin, den Druckkörper 26 mit dem Gegendruckkörper 28 mit Hilfe von Schraubelementen 30 zu verspannen, die in einen Kühlkörper 32 des Leistungshalbleitermodul 10 eingeschraubt sind.

Wie aus Figur 2, in der gleiche Einzelheiten mit denselben Bezugsziffern wie in Figur 1 bezeichnet sind, ersichtlich ist, weist der Druckkörper 26 Druckelemente 34 für die ersten Anschlusselemente 20 und der Gegendruckkörper 28 Druckabschnitte 36 für die zweiten Anschlusselemente 22 der Kondensatoren 12 (siehe Figur 1) auf.

Wie aus Figur 1 des weiteren ersichtlich ist, sind die Kondensatoren 12 zwischen dem Druck- und dem Gegendruckkörper 26 und 28 der Druckeinrichtung 24 festgelegt.

Vom Druckkörper 26 ragen erste Arme 38 weg, an welchen die Druckelemente 34 vorgesehen sind. Vom Druckkörper 26 ragen außerdem zweite Arme 40 weg, die mit Druckorganen 42 gegen die erste Stromschiene 14 gepresst und mit den zweiten Anschlusselementen 22 der Kondensatoren deckungsgleich vorgesehen sind. Die ersten und zweiten Arme 38 und 40 des Druckkörpers 26 sind zueinander parallel und voneinander geringfügig beabstandet vorgesehen. Das jeweilige Druckelement 34 und das dazu benachbarte Druckorgan 42 stehen vom Druckkörper 26 der Druckeinrichtung 24 gleich weit weg.

Wie aus Figur 2 ersichtlich ist, sind die Druckabschnitte 36 durch Rinnen 44 gebildet, die in der der zweiten Stromschiene 16 zugewandten Hauptfläche 46 des Gegendruckkörpers 28 ausgebildet sind. In der jeweiligen Rinne 44 ist ein elastisches Element 48 für das zugehörige zweite Anschlusselement 22 des jeweiligen Kondensator vorgesehen (siehe Figur 3).

Die Kondensatoren 12 sind zwischen dem Druckkörper 26 und dem Gegendruckkörper 28 der Druckeinrichtung 24 definiert nachgiebig festgelegt. Zu diesem Zwecke ragt vom Druckkörper 26 ein längliches Halteorgan 50 weg, das ein Polsterelement 52 aufweist (siehe Figur 1). Der Gegendruckkörper 28 ist mit Positionierelementen 54 für die Kondensatoren 12 ausgebildet. Die Positionierelemente 54 sind als Rippen gestaltet, die den Kondensatoren 12 formmäßig entsprechende Rippenkonturen 58 besitzen.

Gleiche Einzelheiten sind in den Figuren 1, 2 und 3 jeweils mit denselben Bezugsziffern bezeichnet, so dass es sich erübrigt, in Verbindung mit diesen Figuren alle Einzelheiten jeweils detailliert zu beschreiben.

### Bezugsziffernliste:

- 10: Leistungshalbleitermodul
- 12: Kondensatoren (von 10)
- 14: erste Stromschiene (von 10 für 12)
- 16: zweite Stromschiene (von 10 für 12)
- 18: Isolierelement (zwischen 14 und 16)
- 20: erstes Anschlusselement (von 12)
- 22: zweites Anschlusselement (von 12)
- 24: Druckeinrichtung (von 10 für 12)
- 26: Druckkörper (von 24)
- 28: Gegendruckkörper (von 24)
- 30: Schraubelemente (von 24)
- 32: Kühlkörper (von 10)
- 34: Druckelemente (von 26 für 20)
- 36: Druckabschnitte (von 28 für 22)
- 38: erste Arme (von 26 für 34)
- 40: zweite Arme (von 26 für 42)
- 42: Druckorgan (an 40)
- 44: Rinne (von 36)
- 46: Hauptfläche (von 28)
- 48: elastisches Element (in 44)
- 50: Halteorgane (von 26 für 52)
- 52: Polsterelement (an 50 für 12)
- 54: Positionierelemente (von 28 für 12)
- 58: Rippenkontur (von 54)

## Patentansprüche

1. Leistungshalbleitermodul mit zueinander parallel geschalteten Kondensatoren (12), deren erste Anschlusselemente (20) mit einer ersten Stromschiene (14) und deren zweite Anschlusselemente (22) mit einer zweiten Stromschiene (16) kontaktiert sind, wobei zwischen den beiden Stromschienen (14, 16) ein Isolierelement (18) vorgesehen ist, und das eine Druckeinrichtung (24) aufweist, wobei die Druckeinrichtung (24) mindestens einen Druckkörper (26) und einen zugeordneten Gegendruckkörper (28) aufweist, wobei die ersten und zweiten Anschlusselemente (20 und 22) mit den zugeordneten Stromschienen (14, 16) durch die Druckeinrichtung (24) mit Druck beaufschlagt und elektrisch kontaktiert werden **dadurch gekennzeichnet, dass** der mindestens eine Druckkörper (26)zur Druckbeaufschlagung der ersten Anschlusselemente (20) elastisch ausgebildete Arme (38) aufweist und der zugeordnete Gegendruckkörper (28) starr ausgebildet ist, und wobei der mindestens eine Druckkörper (26) zur Druckbeaufschlagung der zweiten Anschlusselemente (22) starr ausgebildete zweite Arme (40) und der zugeordnete Gegendruckkörper (28) elastisch ausgebildete Abschnitte (36, 48) aufweist.

2. Leistungshalbleitermodul nach Anspruch 1,
**dadurch gekennzeichnet,**
**dass** die elastisch ausgebildeten Abschnitte des Gegendruckkörpers (28) als freigestellte Stege ausgebildet sind.

3. Leistungshalbleitermodul nach Anspruch 2,
**dadurch gekennzeichnet,**
**dass** die ersten und zweiten Arme (38 und 40) eng benachbart vorgesehen sind und vom Druckkörper (26) parallel wegragen.

4. Leistungshalbleitermodul nach Anspruch 2,
**dadurch gekennzeichnet,**
**dass** die ersten und zweiten Arme (38 und 40) vom Druckkörper (26) gleich weit wegragen.

5. Leistungshalbleitermodul nach Anspruch 3,
**dadurch gekennzeichnet,**
**dass** die elastisch ausgebildeten Abschnitte (36, 48) des Gegendruckkörpers (28) mit den zweiten Armen (40) des mindestens einen Druckkörpers (26) deckungsgleich vorgesehen sind.

6. Leistungshalbleitermodul nach einem der Ansprüche 1 bis 5,
**dadurch gekennzeichnet,**
**dass** die Kondensatoren (12) zwischen dem Druckkörper (26) und dem Gegendruckkörper (28) der Druckeinrichtung (24) definiert nachgiebig festgelegt sind.

7. Leistungshalbleitermodul nach Anspruch 6,
**dadurch gekennzeichnet,**
**dass** vom Druckkörper (26) ein zur ersten und zweiten Stromschiene (14, 16) parallel orientiertes, längliches Halteorgan (50) wegkragt, das ein Polsterelement (52) aufweist, und dass der Gegendruckkörper (28) mit Positionierelementen (54) für die Kondensatoren (12) ausgebildet ist.

8. Leistungshalbleitermodul nach einem der Ansprüche 1 bis 7,
**dadurch gekennzeichnet,**
**dass** die Kondensatoren (12) zueinander parallel nebeneinander in einer Reihe neben der ersten und zweiten Stromschiene (14, 16) angeordnet sind und mindestens annähernd in der Ebene der ersten und zweiten Stromschiene (14, 16) liegen.

## Claims

1. Power semiconductor module with capacitors (12) connected to one another in parallel, the first connection elements (20) of which are contacted with a first conductor rail (14) and the second connection elements (22) of which are contacted with a second conductor rail (16), wherein an insulator element (18) is provided between the two conductor rails (14, 16), and which has a compression device (24), wherein the compression device (24) has at least one compression body (26) and an associated counterpart compression body (28), wherein the first and second connection elements (20 and 22) are loaded with pressure and electrically contacted with the associated conductor rails (14, 16) by means of the compression device (24), **characterised in that** the at least one compression body (26) for pressure loading the first connection elements (20) has elastically constructed arms (38) and the associated counterpart compression body (28) is constructed rigidly, and wherein the at least one compression body (26) for pressure loading the second connection elements (22) has rigidly constructed second arms (40) and the associated counterpart compression body (28) has elastically constructed sections (36, 48).

2. Power semiconductor module according to Claim 1,
**characterised**
**in that** the elastically constructed sections of the counterpart compression body (28) are constructed as exposed webs.

3. Power semiconductor module according to Claim 2,
**characterised**
**in that** the first and second arms (38 and 40) are provided closely adjacent to one another and project away from the compression body (26) in parallel.

4. Power semiconductor module according to Claim 2,
**characterised**
**in that** the first and second arms (38 and 40) project away from the compression body (26) to the same distance.

5. Power semiconductor module according to Claim 3,
**characterised**
**in that** the elastically constructed sections (36, 48) of the counterpart compression body (28) are provided congruently with the second arms (40) of the at least one compression body (26).

6. Power semiconductor module according to one of Claims 1 to 5,
**characterised**
**in that** the capacitors (12) are fixed in a defined flexible manner between the compression body (26) and the counterpart compression body (28) of the compression device (24).

7. Power semiconductor module according to Claim 6,
**characterised**
**in that** a longitudinal retaining means (50) which is orientated parallel to the first and second conductor rails (14, 16) and has a padding element (52) projects away from the compression body (26) and in that the counterpart compression body (28) is constructed with positioning elements (54) for the capacitors (12).

8. Power semiconductor module according to one of Claims 1 to 7,
**characterised**
**in that** the capacitors (12) are arranged parallel adjacent to one another in a row next to the first and second conductor rails (14, 16) and lie at least approximately in the plane of the first and second conductor rails (14, 16).

## Revendications

1. Module à semi-conducteurs de puissance comprenant des condensateurs (12) branchés parallèlement entre eux, dont les premiers éléments de raccordement (20) et les seconds éléments de raccordement (22) sont mis en contact respectivement avec un premier rail électrique (14) et un second rail électrique (16), un élément isolant (18) étant prévu entre les deux rails électriques (14, 16), et lequel présente un dispositif de pression (24), le dispositif de pression (24) présentant au moins un corps de pression (26) et un corps de contre-pression (28) associé, les premiers et les seconds éléments de raccordement (20 et 22) étant alimentés en pression par le dispositif de pression (24) et mis en contact électriquement avec les rails électriques (14, 16) attribués, **caractérisé en ce que** le au moins un corps de pression (26), pour l'alimentation en pression des premiers éléments de raccordement (20) présente des bras (38) conçus de façon élastique et le corps de contre-pression (28) associé est réalisé de façon rigide, et le au moins un corps de pression (26) pour l'alimentation en pression des seconds éléments de raccordement (22) présentant des seconds bras (40) réalisés de façon rigide et le corps de contre-pression (28) associé présentant des parties (36, 48) conçues de façon élastique.

2. Module à semi-conducteurs de puissance selon la revendication 1,
**caractérisé en ce que**
les parties conçues de façon élastique du corps de contre-pression (28) sont conçues sous forme de barrettes isolées.

3. Module à semi-conducteurs de puissance selon la revendication 2,
**caractérisé en ce que**
les premiers et seconds bras (38 et 40) sont prévus à proximité immédiate et dépassent en parallèle du corps de pression (26).

4. Module à semi-conducteurs de puissance selon la revendication 2,
**caractérisé en ce que**
les premiers et seconds bras (38 et 40) dépassent de façon identique du corps de pression (26).

5. Module à semi-conducteurs de puissance selon la revendication 3,
**caractérisé en ce que**
les parties (36, 48), conçues de façon élastique, du corps de contre-pression (28) avec les deux bras (40) du au moins un corps de pression (26) sont prévues avec un recouvrement identique.

6. Module à semi-conducteurs de puissance selon l'une quelconque des revendications 1 à 5,
**caractérisé en ce que**
les condensateurs (12) sont fixés de façon définie et souple entre le corps de pression (26) et le corps de contre-pression (28) du dispositif de pression (24).

7. Module à semi-conducteurs de puissance selon la revendication 6,
**caractérisé en ce que**
un organe de retenue (50) allongé, orienté parallèlement au premier et au second rail électrique (14, 16), dépasse du corps de pression (26) et présente un élément de rembourrage (52), et **en ce que** le corps de contre-pression (28) est réalisé avec des éléments de positionnement (54) pour les condensateurs (12).

8. Module à semi-conducteurs de puissance selon l'une quelconque des revendications 1 à 7,
**caractérisé en ce que**
les condensateurs (12) sont disposés parallèlement entre eux, les uns à côté des autres, dans une rangée entre le premier et le second rail électrique (14, 16) et se situent au moins approximativement dans le plan du premier et du second rail électrique (14, 16).
